(19) Europäisches Patentamt
European Patent Office
Office européen des brevets

(11) **EP 2 274 905 B1**

(12) **EUROPÄISCHE PATENTSCHRIFT**

(45) Veröffentlichungstag und Bekanntmachung des Hinweises auf die Patenterteilung:
**28.11.2012 Patentblatt 2012/48**

(21) Anmeldenummer: **09745732.9**

(22) Anmeldetag: **12.05.2009**

(51) Int Cl.:
***H04N 9/04*** *(2006.01)*

(86) Internationale Anmeldenummer:
**PCT/EP2009/055710**

(87) Internationale Veröffentlichungsnummer:
**WO 2009/138400 (19.11.2009 Gazette 2009/47)**

(54) **SENSORVORRICHTUNG**

SENSOR DEVICE

DISPOSITIF DE DÉTECTION

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **15.05.2008 DE 102008023612**

(43) Veröffentlichungstag der Anmeldung:
**19.01.2011 Patentblatt 2011/03**

(73) Patentinhaber: **Siemens Aktiengesellschaft 80333 München (DE)**

(72) Erfinder:
• WEVER, Utz
  81539 München (DE)
• ZHENG, Qinghua
  82024 Taufkirchen (DE)

(74) Vertreter: **Wolff, Harry et al
Siemens Aktiengesellschaft
Postfach 22 16 34
80506 München (DE)**

(56) Entgegenhaltungen:
**WO-A-03/054483    WO-A-2005/065129**

EP 2 274 905 B1

**Beschreibung**

Die Erfindung betrifft eine Sensorvorrichtung für ein Bildaufnahmegerät zur sensorischen Erfassung einer Strahlung und ein Verfahren zur Aufnahme eines Bildes.

Sensoranordnungen, die aus Sensorelementen bestehen, werden beispielsweise in elektronischen Kameras vorgesehen. Beispielsweise wird über ein Linsensystem ein Bild auf einen CCD (Charge Couple Device) abgebildet.

Ein derartiges Bild hat aufgrund der großen Anzahl der auf einen CCD vorhandenen Sensorelemente allerdings einen sehr hohen Speicherbedarf. Weiterhin besteht ein sehr hoher Übertragungsbedarf bei der Übertragung der Bilddaten von der Kamera bei einer Datenverarbeitungseinheit.

Zur Minimierung der bei der Übertragung des Bildes übertragenen Daten werden die Bilddaten daher oft einem Datenkompressionsverfahren unterzogen. Beispielsweise werden die Bilddaten dabei einer sogenannten Wavelet-Transformation unterzogen und anschließend komprimiert. Diese Wavelet-Transformation der Bilddaten macht allerdings nicht den Datenspeicher in der Kamera überflüssig bzw. obsolet, da die aufgenommenen Bilddaten vor der Durchführung der Wavelet-Transformation zunächst in einem Datenspeicher zwischengespeichert werden müssen. Ferner muss für die Durchführung der Wavelet-Transformation eine zusätzliche Prozessoreinheit vorgesehen werden, die die technische Komplexität der Kamera erhöht, wobei dies zudem zu einem erhöhten Energiebedarf führt.

Es wird daher in der US 7,362,363 B2 eine Sensoranordnung vorgeschlagen, die bereits bei der Aufnahme eines Bildes eine komprimierte Darstellung des Bildinhaltes generiert, sodass auf eine zusätzliche Prozessoreinheit über die Wavelet-Transformation verzichtet werden kann. Hierzu weist diese bekannte Sensoranordnung mehrere Sensorelemente auf, deren Messwerte durch ein Auslesemittel ausgelesen werden. Zur Durchführung einer Gesamtmessung werden nacheinander mehrere Teilmessungen durchgeführt, wobei ein Auslesemittel das Auslesen der Sensorelemente derart steuert, dass bei den jeweiligen Teilmessungen die Messwerte jeweils unterschiedlicher Sensorelemente addiert und subtrahiert werden.

Diese herkömmliche Sensoranordnung hat allerdings den Nachteil, dass das vorzusehende Auslesemittel zum Auslesen der Messwerte aus den Sensorelementen eine hohe technische Komplexität aufweist, da der Sensor bzw. die Sensoranordnung variabel Pixel für Pixel verschaltbar sein muss. Die Herstellung einer derartigen Sensoranordnung, insbesondere bei einer Integration auf einem Chip, ist daher sehr aufwändig. Darüber hinaus benötigt das komplexe Auslesemittel bei einer Integration aufgrund seiner Komplexität viel Raum.

Es ist daher eine Aufgabe der vorliegenden Erfindung, eine Sensorvorrichtung zur Aufnahme eines Bildes zu schaffen, das eine komprimierte Darstellung des Bildinhaltes liefert und gleichzeitig eine möglichst geringe technische Komplexität aufweist.

Diese Aufgabe wird erfindungsgemäß durch eine Sensorvorrichtung mit den im Patentanspruch 1 angegebenen Merkmalen gelöst.

Die Erfindung schafft eine Sensorvorrichtung mit mehreren übereinander angeordneten Sensorschichten, die jeweils aus Sensorelementen bestehen, wobei in jeder Sensorschicht durch die Sensorelemente Koeffizienten von Basis-Funktion einer Detailebene sensorisch erfasst werden, wobei die Sensorelemente der Sensorschichten fest verdrahtet sind und jeweils direkt einen Messwert liefern, dessen Größe einem Koeffizienten der Basis-Funktion entspricht.

Ein Vorteil der erfindungsgemäßen Sensorherstellung besteht darin, dass durch die feste Verdrahtung der Sensorelemente der verschiedenen Sensorschichten die Schaltungslogik der Sensorvorrichtung gegenüber einer herkömmlichen Sensoranordnung vereinfacht wird.

Bei der erfindungsgemäßen Sensorvorrichtung sind die Sensorelemente nicht variabel Pixel für Pixel verschaltbar, sondern die Sensorelemente in den Sensorschichten bzw. Sensorebenen sind fest verdrahtet. Die fest verdrahteten Sensorelemente der verschiedenen Sensorschichten werden gleichzeitig belichtet. Das einfallende Licht bzw. die Strahlung wird gleichzeitig von allen Sensorelementen auf allen Sensorschichten bzw. Sensorebenen genutzt.

Bei der erfindungsgemäßen Sensorvorrichtung wird die Basis-Funktion durch eine Wavelet-Basisfunktion gebildet.

Bei einer Ausführungsform der erfindungsgemäßen Sensorvorrichtung liefert die Sensorvorrichtung eine Bildaufnahme einer auf einer Oberfläche einer obersten Sensorschicht auftreffenden Strahlung.

Bei dieser Strahlung kann es sich um eine beliebige Strahlung, insbesondere um eine elektromagnetische Strahlung, eine Röntgenstrahlung, eine Gammastrahlung oder um eine Teilchenstrahlung handeln.

Die erfindungsgemäße Sensorvorrichtung ist somit vielseitig und flexibel für unterschiedlichste Anwendungsgebiete einsetzbar.

Bei einer Ausführungsform der erfindungsgemäßen Sensorvorrichtung vermindert sich eine Auflösungsfrequenz einer Sensorschicht mit zunehmender Tiefe der Sensorschicht ausgehend von der Oberfläche und die Auflösungswellenlänge einer Sensorschicht erhöht sich mit zunehmender Tiefe der Sensorschicht ausgehend von der Oberfläche.

Bei einer Ausführungsform der erfindungsgemäßen Sensorvorrichtung ist die Auflösungsfrequenz einer unterhalb einer Sensorschicht liegenden weiteren Sensorschicht jeweils halb so groß wie die Auflösungsfrequenz der darüberliegenden Sensorschicht.

Bei einer Ausführungsform der erfindungsgemäßen Sensorvorrichtung ist die verwendete Wavelet-Basisfunktion eine Haar-Wavelet-Funktion.

Bei einer weiteren Ausführungsform der erfindungsgemäßen Sensorvorrichtung ist die Wavelet-Basisfunktion eine Coiflet-Wavelet-Funktion.

Bei einer möglichen weiteren Ausführungsform der erfindungsgemäßen Sensorvorrichtung ist die Wavelet-Basisfunktion eine Gabor-Wavelet-Basisfunktion.

Bei einer weiteren Ausführungsform der erfindungsgemäßen Sensorvorrichtung ist die eingesetzte Wavelet-Basisfunktion eine Daubechies-Wavelet-Basisfunktion.

Bei einer weiteren Ausführungsform der erfindungsgemäßen Sensorvorrichtung ist die eingesetzte Wavelet-Basisfunktion eine Johnston-Barnard-Wavelet-Funktion.

Bei einer weiteren möglichen Ausführungsform der erfindungsgemäßen Sensorvorrichtung ist die eingesetzte Wavelet-Basisfunktion eine Bio-orthogonal-Spline-Wavelet-Basisfunktion.

Bei weiteren möglichen Ausführungsformen können weitere, oben nicht spezifisch genannte Wavelet-Basisfunktionen eingesetzt werden.

Bei einer möglichen Ausführungsform der erfindungsgemäßen Sensorvorrichtung sind die Sensorelemente CCD-Sensorelemente.

Bei einer alternativen Ausführungsform der erfindungsgemäßen Sensorvorrichtung sind die Sensorelemente CMOS-Sensorelemente.

Bei einer Ausführungsform der erfindungsgemäßen Sensorvorrichtung bestehen die Sensorschichten aus einem strahlungsdurchlässigen Material.

Bei einer Ausführungsform der erfindungsgemäßen Sensorvorrichtung entspricht die Gesamtaufnahmezeit der Sensorvorrichtung der Mindestbelichtungsdauer der obersten Sensorschicht mit der höchsten Auflösungsfrequenz und mit der geringsten Auflösungswellenlänge.

Bei einer Ausführungsform der erfindungsgemäßen Sensorvorrichtung ist die Mindestbelichtungsdauer einer Sensorschicht umgekehrt proportional zur Aufnahmefläche eines Sensorelementes in der jeweiligen Sensorschicht.

Bei einer Ausführungsform der erfindungsgemäßen Sensorvorrichtung nimmt die Mindestbelichtungsdauer einer Sensorschicht mit zunehmender Tiefe der Sensorschicht ausgehend von der Oberfläche der Sensorvorrichtung exponentiell ab.

Bei einer Ausführungsform der erfindungsgemäßen Sensorvorrichtung nimmt die Aufnahmefläche eines Sensorelementes einer Sensorschicht mit zunehmender Tiefe der Sensorschicht ausgehend von der Oberfläche der Sensorvorrichtung exponentiell zu.

Bei einer Ausführungsform der erfindungsgemäßen Sensorvorrichtung weist die Sensorvorrichtung bei einer Auflösung von $2^N$ Pixeln N übereinander angeordnete Sensorschichten auf.

Die Erfindung schafft ferner ein Bildaufnahmegerät mit einer Sensorvorrichtung, die aus mehreren übereinander angeordneten Sensorschichten besteht, die jeweils Sensorelemente aufweisen, wobei in jeder Sensorschicht durch Sensorelemente Koeffizienten einer Basis-Funktion sensorisch erfasst werden und wobei die Sensorelemente der Sensorschichten fest verdrahtet sind und jeweils direkt einen Messwert liefern, dessen Größe einem Koeffizienten der Basis-Funktion entspricht.

Bei einer Ausführungsform des Bildaufnahmegerätes gemäß der Erfindung weist das Bildaufnahmegerät ferner eine Signalverarbeitungsvorrichtung auf.

Bei einer möglichen Ausführungsform handelt es sich bei der Signalverarbeitungsvorrichtung um eine Signal- bzw. Datenkompressionseinheit.

Bei einer weiteren Ausführungsform des Bildaufnahmegerätes ist die vorgesehene Signalverarbeitungseinheit eine Signalfiltereinheit.

Bei einer weiteren möglichen Ausführungsform ist die in dem Bildaufnahmegerät vorgesehene Signalverarbeitungsvorrichtung eine Signalrauschunterdrückungseinheit.

Bei einer möglichen Ausführungsform des Bildaufnahmegerätes werden die sensorisch erfassten Koeffizienten der Basisfunktion in einem Datenspeicher zwischengespeichert.

Bei einer weiteren möglichen Ausführungsform des Bildaufnahmegerätes ist eine Berechnungseinheit zur Berechnung einer inversen Wavelet-Transformation vorgesehen, die an einen Bildschirm angeschlossen ist.

Die Erfindung schafft ferner einen Satelliten mit einer Sensorvorrichtung, welche mehrere übereinander angeordnete Sensorschichten aufweist, die jeweils aus Sensorelementen bestehen, wobei in jeder Sensorschicht durch die Sensorelemente Koeffizienten einer Basisfunktion sensorisch erfasst werden, wobei die Sensorelementen der Sensorschichten fest verdrahtet sind und jeweils direkt einen Messwert liefern, dessen Größe einem Koeffizienten der Basis-Funktion entspricht, wobei die sensorisch erfassten Koeffizienten der Basis-Funktion über eine Funkschnittstelle des Satelliten an eine Signalverarbeitungsvorrichtung innerhalb einer Bodenstation übertragen werden.

Die Erfindung schafft ferner ein Röntgengerät mit einer Sensorvorrichtung, die mehrere übereinander angeordnete Sensorschichten aufweist, die jeweils aus Sensorelementen bestehen, wobei in jeder Sensorschicht durch die Sensorelemente Koeffizienten einer Basis-Funktion sensorisch erfasst werden, wobei die Sensorelemente der Sensorschichten fest verdrahtet sind und jeweils direkt einen Messwert liefern, dessen Größe einem Koeffizienten der Basis-Funktion entspricht.

Die Erfindung schafft ferner einen Tomographen mit einer Sensorvorrichtung, die mehrere übereinander angeordnete Sensorschichten aufweist, die jeweils aus Sensorelementen bestehen, wobei in jeder Sensorschicht durch die Sensorelemente Koeffizienten einer Basis-Funktion sensorisch erfasst werden, wobei die Sensorelemente der Sensorschichten fest verdrahtet sind und jeweils direkt einen Messwert liefern, dessen Größe einem Koeffizienten der Basisfunktion entspricht.

Die Erfindung schafft ferner ein Verfahren zur Aufnahme eines Bildes nach Anspruch 21.

Bei dem erfindungsgemäßen Verfahren wird die eingesetzte Basis-Funktion durch eine Wavelet-Basisfunktion gebildet.

Im Weiteren werden Ausführungsformen der erfindungsgemäßen Sensorvorrichtung und des erfindungsgemäßen Verfahrens zur Aufnahme eines Bildes unter Bezugnahme auf die beigefügten Figuren beschrieben.

Es zeigen:

Figur 1: eine schematische Schnittansicht durch eine Sensorvorrichtung gemäß der Erfindung;

Figur 2: eine weitere Schnittansicht zur Darstellung einer Ausführungsform der erfindungsgemäßen Sensorvorrichtung;

Figuren 3A, 3B: schematische Darstellungen zur Erläuterung der Funktionsweise eines bei der erfindungsgemäßen Sensorvorrichtung eingesetzten Sensorelementes gegenüber einem herkömmlichen Sensorelement. Die dargestellte Sensorvorrichtung misst eine Haar-Basis;

Figur 4: eine schematische Darstellung einer möglichen Ausführungsform der erfindungsgemäßen Sensorvorrichtung zur Erläuterung von deren Funktionsweise;

Figur 5: Diagramme zur Erläuterung einer besonderen Ausführungsform der erfindungsgemäßen Sensorvorrichtung;

Figur 6: ein Blockschaltdiagramm zur Darstellung einer möglichen Ausführungsform eines Bildaufnahmegerätes, bei dem die erfindungsgemäße Sensorvorrichtung eingesetzt wird;

Figur 7: ein Blockschaltbild zur Darstellung eines Ausführungsbeispiels eines Satelliten, bei dem die erfindungsgemäße Sensorvorrichtung eingesetzt wird.

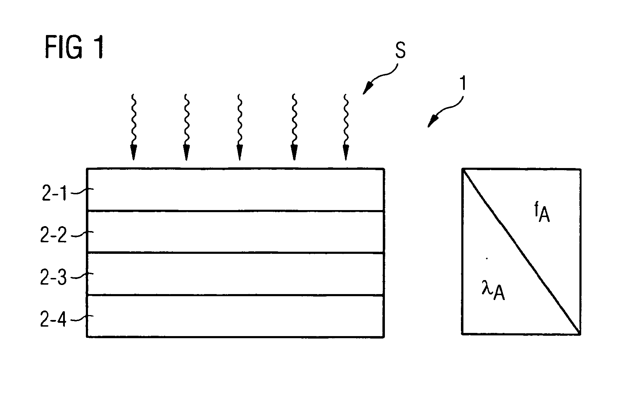

Wie man aus Figur 1 erkennen kann, weist die erfindungsgemäße Sensorvorrichtung 1 mehrere übereinander angeordnete Sensorschichten, 2-1, 2-2, 2-3, 2-4 auf. Bei dem in Figur 1 dargestellten Beispiel weist die Sensorvorrichtung 1 $N = 4$ übereinander angeordnete Sensorschichten 2 auf. Die Anzahl N der übereinander angeordneten Sensorschichten kann variieren. Bei einer Sensorvorrichtung 1 mit einer Auflösung von $2^N$ Pixeln werden vorzugsweise N übereinander angeordnete Sensorschichten 2 vorgesehen. Wie in Figur 1 schematisch dargestellt, fällt auf die oberste Sensorschicht 2-1 der Sensorvorrichtung 1 eine Strahlung S. Die Sensorvorrichtung 1 liefert eine Aufnahme der auftreffenden Strahlung S. Bei der Strahlung S kann es sich um eine beliebige Strahlung, insbesondere um eine elektromagnetische Strahlung, eine Röntgenstrahlung, eine Gammastrahlung oder eine Teilchenstrahlung handeln. In jeder Sensorschicht 2-i sind flächig Sensorelemente vorgesehen, die Koeffizienten c einer Basisfunktion BF sensorisch erfassen. Dabei sind die Sensorelemente der Sensorschichten 2 fest verdrahtet und liefern direkt jeweils einen Messwert, dessen Größe einem Koeffizienten c der Basis-Funktion BF entspricht. Als Basis-Funktion BF wird vorzugsweise eine Wavelet-Basisfunktion W-BF eingesetzt. Die Sensorvorrichtung 1 liefert eine Bildaufnahme der auf die Oberfläche der obersten Sensorschicht 2-1 auftreffenden Strahlung S.

Wie in Figur 1 schematisch angedeutet, vermindert sich dabei vorzugsweise eine Auflösungsfrequenz $f_A$ einer Sensorschicht 2 mit zunehmender Tiefe der Sensorschicht ausgehend von der Oberfläche, auf welche die Strahlung S trifft. Gleichzeitig erhöht sich die Auflösungswellenlänge $\lambda_A$ einer Sensorschicht 2 mit zunehmender Tiefe der Sensorschicht ausgehend von der Oberfläche, auf welche die Strahlung S trifft. Bei dem in Figur 1 dargestellten Ausführungsbeispiel weist somit die oberste Sensorschicht 2-1 die höchste Auflösungsfrequenz $f_A$ und gleichzeitig die geringste Auflösungswellenlänge $\lambda_A$ auf. Umgekehrt weist die unterste Sensorschicht 2-4 die geringste Auflösungsfrequenz $f_A$ und die höchste Auflösungswellenlänge $\lambda_A$ auf.

Bei einer möglichen Ausführungsform der erfindungsgemäßen Sensorvorrichtung 1 ist die Auflösungsfrequenz $f_A$ einer unterhalb einer Sensorschicht 2-i liegenden weiteren Sensorschichten 2-(i+1) jeweils halb so groß wie die Auflösungsfrequenz der darüberliegenden Sensorschicht 2-i.

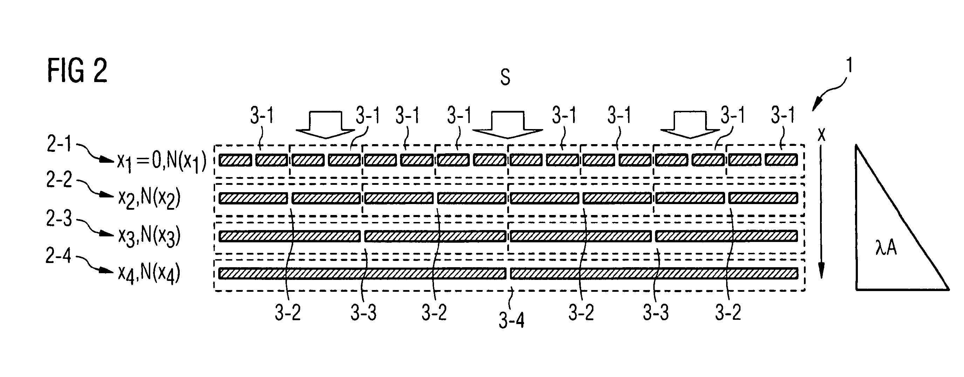

Figur 2 zeigt ebenfalls schematisch eine Schnittansicht durch die in Figur 1 dargestellte Sensorvorrichtung 1. Wie in Figur 2 dargestellt, befindet sich in jeder Sensorschicht 2-i eine Vielzahl von Sensorelementen 3-i. Bei dem in Figur 2 schematisch dargestellten Beispiel befinden sich in der obersten Sensorschicht 2-1 acht Sensorelemente 3-1, in der zweiten Sensorschicht 2-2 vier Sensorelemente 3-2, in der dritten Sensorschicht 2-3 drei Sensorelemente 3-3, in der untersten Sensorschicht 2-4 ein einziges Sensorelement 3-4. Wie man aus Figur 2 erkennen kann, nimmt die Größe bzw. die Aufnahmefläche der Sensorelemente 3-i mit zunehmender Tiefe der Sensorschicht zu. Bei einer möglichen Ausführungsform der erfindungsgemäßen Sensorvorrichtung 1 verdoppelt sich die Aufnahmefläche eines Sensorelementes 3-i bei jeder weiteren Sensorschicht ausgehend von der obersten Sensorschicht 2-1 hin bis zur untersten Sensorschicht 2-N.

Bei den Sensorelementen 3-i kann es sich um CMOS- (Complementary Metal Oxid Semiconductor) Sensorelemente handeln. Bei einer alternativen Ausführungsform sind die Sensorelemente 3-i CCD- (Charge Couple Device) Sensorelemente.

Die Sensorschichten 2-i der Sensorvorrichtung 1 bestehen aus einem strahlungsdurchlässigen Material, wobei das Material von einer jeweiligen Art der aufnehmenden Strahlung S abhängt. Die Absorbtion der Strahlung S wird durch ein Exponentialgesetz beschrieben, das Lambert-Beersche-Gesetz:

$$\frac{dN}{dx} = -\mu N(x) \Rightarrow N(x) = N(0)e^{-\mu x}$$

Die Belichtungsdauer ist umgekehrt proportional zur Aufnahmefläche und nimmt exponentiell mit der Verfeinerungsebene bzw. mit Tiefe der Sensorschicht 2-i ausgehend von der Oberfläche ab.

Bei einer Ausführungsform der erfindungsgemäßen Sensorvorrichtung 1 wird durch die geeignete Anordnungstiefe der verdrahteten Sensorschichten 2-i dieses Absorbtionsgesetz für die korrekte Belichtung der Sensorebene bzw. Sensorschichten ausgenutzt. Dabei wird die Einbautiefe x der Sensorschichten 2-i und die Photonenenergie für die Belichtung zur Dimensionierung der Sensorvorrichtung 1 berechnet.

Bei einer möglichen Ausführungsform der erfindungsgemäßen Sensorvorrichtung 1 ergibt sich die Einbautiefe in einer Sensorschicht 2-i gemäß dem Lambertschen Gesetz M(x) = N(0) $e^{-\mu x}$, wobei $\mu$ abhängig vom Material und der Frequenz der zu messenden Strahlung ist. Beträgt die normierte Belichtung 1, wird die Oberfläche x1 = 0 mit der Intensität N(x1) = ½ belichtet. Die Einbautiefe x2 für die zweite Sensorschicht 2-2 ergibt sich abhängig von der Materialkonstante $\mu$ entsprechend ¼ der Intensität des Lichtes:

$$\mathrm{N(x2)} = ¼ = ½\ e^{-\mu x2},$$

d. h. die Einbautiefe für die zweite Sensorschicht 2-2 ergibt sich zu:

$$x_2 = -\frac{1}{\mu}\ \ln\left(\frac{1}{2}\right).$$

Die Einbautiefe x3 für die nächste Sensorschicht 2-3 ergibt sich derart, dass abhängig von der Materialkonstante $\mu$ mindestens noch ein 1/8 der Lichtintensität bzw. Strahlungsintensität dort ankommt:

$$\mathrm{N(x3)} = 1/8 = ½\ e^{-\mu x3}.$$

Das heißt die Einbautiefe x3 der dritten Sensorschicht 2-3 ergibt sich wie folgt:

$$x_3 = -\frac{1}{\mu} \ln\left(\frac{1}{4}\right).$$

Analog ergibt sich für die Einbautiefe der vierten Sensorschicht 2-4:

$$N(x4) = 1/16 = \tfrac{1}{2}\, e^{-\mu x4}.$$

$$\text{Das heißt } x_4 = -\frac{1}{\mu} \ln\left(\frac{1}{8}\right).$$

Die Einbautiefe $x_4$ der untersten Sensorschicht 2-4 ergibt die Dicke der erfindungsgemäßen Sensorvorrichtung 1. Die Dicke der erfindungsgemäßen Sensorvorrichtung 1 hängt somit von der Konstante $\mu$ des verwendeten Materials für die Sensorelemente 3 ab, das seinerseits von der zu erfassenden Strahlung S bestimmt ist.

Bei der erfindungsgemäßen Sensorvorrichtung 1, wie sie in Figur 2 dargestellt ist, werden mehrere hintereinander geschichtete strahlungsdurchlässige Sensorelemente verschiedener Sensorschichten 2 mit der von derselben Strahlungsquelle stammenden Strahlung S belichtet. Die Intensität der Strahlung S nimmt dabei exponentiell mit einer Eindringtiefe x der Strahlung S in die Sensorvorrichtung 1 ab. Die Sensorelemente 3-i der verschiedenen Sensorschichten 2-i sind derart dimensioniert, dass sie mit zunehmender Eindringtiefe exponentiell weniger Strahlung benötigen, d. h. die Aufnahmefläche der Sensorelemente 3 nimmt mit zunehmender Schichttiefe $x_i$ der jeweiligen Sensorschicht 2-i zu, wie schematisch in Figur 2 dargestellt.

Die Sensorelemente 3-i sind strahlendurchlässig und werden hintereinander geschaltet. Die benötigte minimale Gesamtaufnahmezeit wird dabei durch die erste Sensorschicht 2-i bzw. Sensorebene bestimmt. Die Gesamtaufnahmezeit der Sensorvorrichtung 1 entspricht der Mindestbelichtungsdauer der obersten Sensorschicht 2-1 mit der höchsten Auflösungsfrequenz $f_A$ und mit der geringsten Auflösungswellenlänge $\lambda_A$. Dadurch, dass die hintereinander geschalteten linearen Sensorelemente 3-i gleichzeitig belichtet werden, wird bei der erfindungsgemäßen Sensorvorrichtung 1 die Hälfte der Belichtung eingespart, da die einfallende Bestrahlung für alle Sensorschichten 2-i benutzt wird. Die feinste Sensorebene bzw. die oberste Sensorschicht 2-1 benötigt aufgrund einer Differenzmessung die Hälfte der konventionellen Belichtung. Durch zusätzliche Belichtung der tieferen Sensorebenen bzw. Sensorschichten kann die absorbierte Reststrahlung ausgenutzt werden. Dabei addiert sich die volle Intensität und damit die gleiche Bildqualität wie folgt:

$$\sum_{i=1}^{\infty} 2^{-i} = 1,$$

wobei i der Sensorschicht 2-i ist.

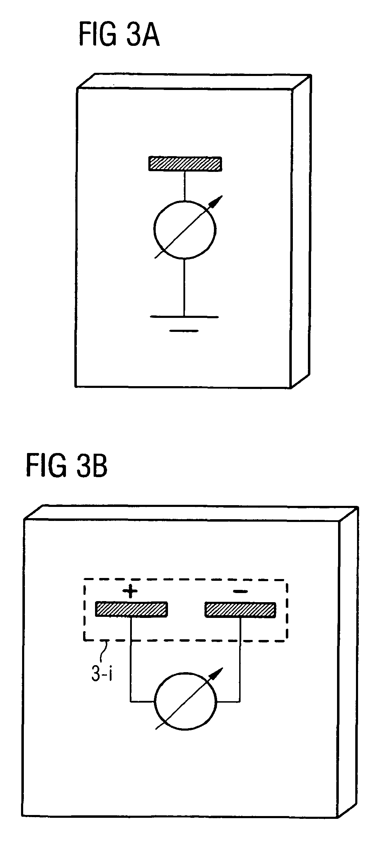

In Figuren 3A, 3B ist die Belichtungsmessung an einem Sensorelement 3-i der erfindungsgemäßen Sensorvorrichtung 1 (Figur 3B) im Vergleich zu der Belichtungsmessung durch ein konventionelles Sensorelement (Figur 3A) schematisch dargestellt. Für die gleiche Pixelgröße braucht eine konventionelle Belichtungsmessung doppelt so lange wie eine Differenzmessung, weil die Differenzmessung zwei Pixel für die Belichtungsmessung benutzt. Die Differenzmessung kann in jeder Sensorschicht 2-i gleichzeitig vorgenommen werden.

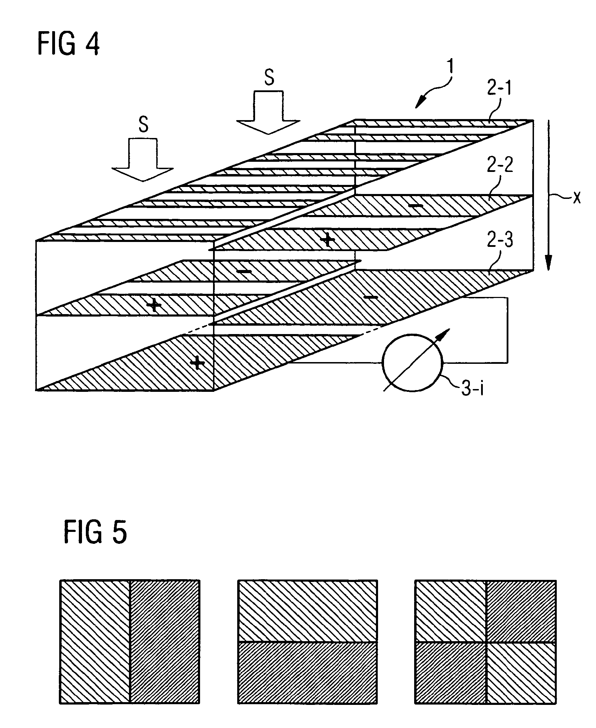

Figur 4 zeigt schematisch den Aufbau einer erfindungsgemäßen Sensorvorrichtung 1 mit drei Sensorschichten 2-1, 2-2, 2-3. Auf die Oberfläche der obersten Sensorschicht 2-1 fällt eine Strahlung S, beispielsweise eine Lichtstrahlung oder eine Teilchenstrahlung. Wie man erkennen kann, ist die Aufnahmefläche des einzigen Sensorelementes innerhalb der untersten Sensorschicht 2-3 deutlich größer als die Aufnahmefläche der in der obersten Sensorschicht 2-1 befindlichen Sensorelemente.

Figur 5 zeigt ein Diagramm zur Verdeutlichung einer möglichen Ausführungsform der erfindungsgemäßen Sensorvorrichtung 1. Bei dieser Ausführungsform sind in jeder Sensorschicht 2-i ihrerseits mehrere Subschichten vorgesehen. Beispielsweise können, wie in Figur 5 dargestellt, drei Sub- bzw. Unterschichten vorgesehen werden. Bei diesem Ausführungsbeispiel werden pro Sensorschicht bzw. Sensorebene 2-i drei Differenzmessungen in jeweils einem Viertel der Belichtungszeit vorgenommen. Damit addieren sich die Intensitäten der aufgenommenen Schichten zu 1 :

$$3\sum_{i=1}^{\infty} 4^{-i} = 1$$

Bei der erfindungsgemäßen Sensorvorrichtung 1, wie sie schematisch in den Ausführungsbeispielen gemäß Figuren 1 bis 5 dargestellt ist, werden durch die Sensorelemente 3-i jeder Sensorschicht 2-i Koeffizienten c einer Basis-Funktion BF sensorisch erfasst. Bei einer bevorzugten Ausführungsform handelt es sich bei dieser Basis-Funktion BF um eine sogenannte Wavelet-Basisfunktion. Im Gegensatz zu Sinus- und Kosinus-Funktionen, die beispielsweise bei der FourierTransformation eingesetzt werden, besitzen Wavelet-Funktionen nicht nur Lokalität im Frequenzspektrum, sondern auch im Zeitbereich bzw im Ortsbereich, d. h. sie besitzen sowohl im Frequenzspektrum als auch im Zeitbereich oder Ortsbereich eine geringe Streuung. Durch die Transformation werden die Bilddaten in eine Darstellungsform gebracht, welche Vorteile bei anschließenden Operationen bzw. Signalverarbeitungs bietet. Die direkte Generierung von Wavelet-Koeffizienten durch die erfindungsgemäße Sensorvorrichtung 1 bietet den Vorteil, dass keine eigenständige Verarbeitungseinheit bzw. Transformationseinheit zur Durchführung von derartigen Wavelet-Transformationen vorgesehen werden muss. Im Gegensatz zu periodischen Basis-Funktionen, wie sie bei der FourierTransformation benutzt werden, eignen sich lokale Basis-Funktionen, wie Wavelet-Basisfunktionen, die sowohl im Zeit-(Orts-)als auch im Frequenzbereich endliche Intervalle belegen, besonders für Signalunstetigkeiten. Aufgrund der Lokalität der Wavelet-Basisfunktionen können daher auch besonders steile Flanken von Funktionen optimal dargestellt werden. Die Basis-Funktionen umfassen sogenannte Scaling-Funktionen und Wavelet-Basisfunktionen. Diese Funktionen haben die grundlegenden Eigenschaften der Orthogonalität, d. h. die Vektoren der Funktionen stehen senkrecht zueinander, wodurch eine Transformation und eine identische Rekonstruktion ermöglicht wird. Die Basis-Funktionen ermöglicht aufgrund ihrer endlichen Ausdehnung eine Analyse von Bilddaten ohne Fenstereffekte.

Bei einer Ausführungsform der erfindungsgemäßen Sensorvorrichtung 1 bilden die fest verdrahteten Sensorelemente 3-i der Sensorschichten 2-i jeweils einen Messwert, dessen Größe einem Koeffizienten c der Basis-Funktion BF, insbesondere einer Wavelet-Basisfunktion entspricht.

Bei einer möglichen Ausführungsform der erfindungsgemäßen Sensorvorrichtung 1 ist die Wavelet-Basisfunktion eine Haar-Wavelet-Basisfunktion.

Bei alternativen Ausführungsformen können auch andere Wavelet-Basisfunktionen verwendet werden, beispielsweise eine Coiflet-Wavelet-Basisfunktion, eine Gabor-Wavelet-Basisfunktion, eine Daubechies-Wavelet-Basisfunktion, eine Johnston-Barnard-Wavelet-Basisfunktion oder eine Biorthogonal-Spline-Wavelet-Basisfunktion.

Die Sensorvorrichtung 1 gemäß der Erfindung hat bei einer Auflösung von $2^N$ Pixeln N übereinander angeordnete Sensorschichten 2-i. Beispielsweise weist die Sensorvorrichtung 1 bei einer Auflösung von $1024 = 10^{10}$ Pixeln eine lineare Anordnung von 10 übereinander geschichteten Sensorschichten 2-i auf.

Bei einer möglichen Ausführungsform der erfindungsgemäßen Sensorvorrichtung 1 werden in einer Sensorschicht 2-i mehrere Pixel mit Vorfaktoren verknüpft bzw. multipliziert. Dabei ergeben sich die Vorfaktoren aus der Konstruktion der Wavelets. Durch höhere Wavelets lassen sich Sensorschichten bzw. Sensorebenen einsparen.

Das Material der Sensorelemente 3 sowie die Teilchenenergie werden derart gewählt, dass der Absorbtionskoeffizient einen geeigneten Wert aufweist und die dazugehörige Schichttiefe der einzelnen Sensoren konstruierbar ist.

Bei einer möglichen Ausführungsform können Sensoren 3 aus einzelnen Gruppen bestehen. Zur Streuung der Strahlen, die durch höherliegende Sensoren bzw. Sensorelemente in darübergelegenen Sensorschichten 2 verursacht werden, werden bei der erfindungsgemäßen Sensorvorrichtung 1 durch vergrößerte Flächen bzw. Aufnahmeflächen der unteren Sensorelemente der darunterliegenden Sensorschichten ausgenutzt.

Bei einer Ausführungsform der erfindungsgemäßen Sensorvorrichtung 1 wird als Basis-Funktion BF eine Haar-Wavelet-Basisfunktion eingesetzt.

Die Haar-Wavelet-Basisfunktion ist definiert durch:

$$\psi(x) = \begin{cases} 1 \ \textit{für} \ 0 \le x < \dfrac{1}{2} \\ -1 \ \textit{für} \left( \dfrac{1}{2} \le x < 1 \right) \\ 0 \ \textit{sonst} \end{cases}$$

Die Waveletbasis ist dann definiert als

$$\Psi_{m,n}(x) = 2^{-m} \Psi (2^{-m}x - n), \quad m = 1, \ldots, L, \quad n = 0, \ldots, 2^{L-m} - 1,$$

wobei n den Ort auflöst, m die Ortsfrequenz oder den Detailierungsgrad angibt.

Funktionen können dargestellt werden als Wavelet-Reihe:

$$f = f^{L+1} + \sum_{m=L}^{1} \sum_{l=0}^{2^{L-m}-1} c_{m,l} \, \Psi_{m,l}(x)$$

Die Funktion f (das aufzunehmende Bild) ist durch $2^L$ diskrete Punkte gegeben:

$$f = \{f\}_i, \quad i = 0, \ldots, 2^L - 1$$

Es gibt L Schichten. Gemessen werden in einer Schicht m mit m : $1 \le m \le L$ die Wavelet-Koeffizienten einer Detailebene:

$$c_{m,l}, \quad l = 0, \ldots, 2^{L-m} - 1$$

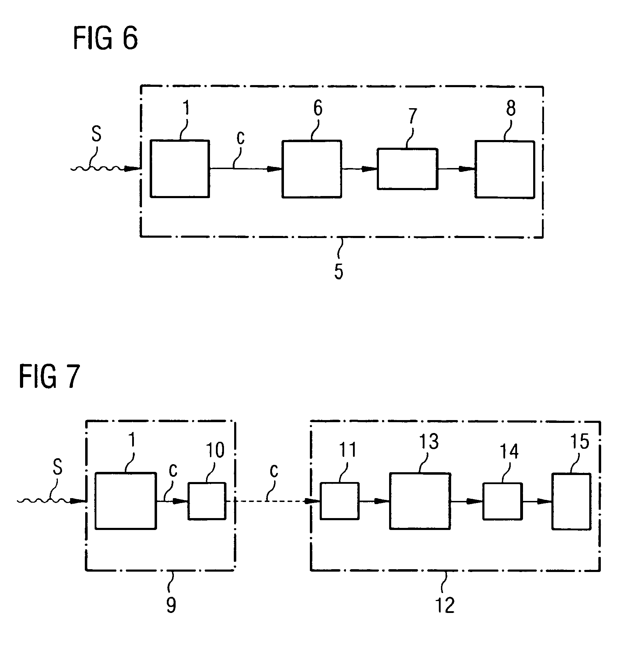

Figur 6 zeigt ein Blockschaltbild einer möglichen Ausführungsform eines Bildaufnahmegerätes 5, das eine Sensorvorrichtung 1 gemäß der Erfindung enthält. Die Sensorvorrichtung 1 liefert direkt Messwerte deren Größe bzw. Höhe jeweils einen Koeffizienten c der implementierten Basis-Funktion BF entspricht. Diese Koeffizienten c werden an eine Signalverarbeitungseinrichtung 6 innerhalb des Bildaufnahmegerätes 5 abgegeben. Bei einer möglichen Ausführungsform werden die generierten Koeffizienten c zunächst in einen Zwischenspeicher zwischengespeichert. Bei der Signalverarbeitungsvorrichtung 6 kann es sich um eine Signalkompressionseinheit, eine Signalfiltereinheit oder auch um eine Signalrauschunterdrückungseinheit handeln. Die verarbeiteten Koeffizienten c können dann einer Berechnungseinheit 7 zugeführt werden, welche eine inverse Transformation, insbesondere eine inverse Wavelet-Transformation durchführt. Die Transformationseinheit 7 liefert ein auf einem Bildschirm 8 darstellbares Bild der durch die Sensorvorrichtung 1 aufgenommenen Strahlung S. Bei dem Bildaufnahmegerät 5, wie es in Figur 6 dargestellt ist, kann es sich beispielsweise um eine Kamera handeln. Weiterhin kann es sich bei dem Bildaufnahmegerät 5 auch um ein Röntgengerät zur Aufnahme einer Röntgenstrahlung S handeln. Ein weiteres Anwendungsbeispiel für das in Figur 6 dargestellte Gerät 5 ist ein Tomograph.

Figur 7 zeigt ein weiteres Anwendungsbeispiel der erfindungsgemäßen Sensorvorrichtung 1. Bei diesem Anwendungsbeispiel ist die Sensorvorrichtung 1 in einem Satelliten 9 vorgesehen und liefert Koeffizienten c einer Basis-Funktion BF, um zu einer Sendeeinrichtung 10 des Satelliten 9, welcher die Koeffizienten c über eine Funkschnittstelle an eine Empfangseinheit 11 innerhalb einer Bodenstation 12 überträgt. In der Bodenstation 12 kann eine Signalverarbeitungsvorrichtung 13 zur Verarbeitung der übertragenen Koeffizienten c vorgesehen sein. Diese verarbeiteten Koeffizienten können durch eine Berechnungseinheit 14 einer inversen Transformation unterzogen werden und auf einem Bildschirm 15 der Bodenstation 12 dargestellt werden.

Die erfindungsgemäße Sensorvorrichtung 1 nutzt durch schichtweise Anordnung von Sensorgruppen bzw. Sensorelementen 3 eine Reststrahlung sukzessive aus.

Die gleichzeitige Belichtung der Sensorgruppen bietet insbesondere folgende Vorteile:

Bei gleicher Strahlungsintensität und Auflösung erfolgt die Belichtung der Sensorgruppen mit einer kürzeren Belichtungszeit.

Bei gleicher Belichtungszeit und Auflösung führt die gleichzeitige Belichtung der Sensorgruppen zu einer niedrigeren notwendigen Strahlungsintensität der Strahlung S.

Bei gleicher Strahlungsintensität und Belichtung führt die gleichzeitige Belichtung der Sensorgruppen zu einer höheren Auflösung.

Die erfindungsgemäße Sensorvorrichtung 1 bietet zudem den Vorteil, dass durch hinreichend lange Aufzeichnung bzw. Belichtung stets eine maximale Auflösung erreicht werden kann.

Die erfindungsgemäße Sensorvorrichtung 1 bietet vor allem den Vorteil, dass die benötigte Information bzw. die Bilddaten direkt in kompakter Form vorliegen bzw. generiert werden und somit ein notwendiger Speicherbedarf minimiert wird.

Die erfindungsgemäße Speichervorrichtung bietet zudem eine hohe Flexibilität bei der Anpassung für verschiedene Anwendungsgebiete.

Bei einer möglichen Ausführungsform können bekannte Störfrequenzen von Störsignalquellen direkt bei der Aufnahme des Bildes unterdrückt werden, indem man gezielt Sensorebenen bzw. Sensorschichten 2-i weglässt bzw. nicht implementiert. Die Messzeit bzw. die Belichtungszeit kann während der Belichtung unabhängig vom Ort optimiert werden. Die gesamte Messzeit der Sensorvorrichtung 1 muss daher nicht a priori vorgegeben werden.

Die erfindungsgemäße Sensorvorrichtung 1 bietet ferner eine hohe Aufzeichnungsdynamik, da Differenzen von Intensitäten gemessen werden und keine Absolutwerte.

Die erfindungsgemäße Sensorvorrichtung 1 eignet sich für unterschiedlichste Anwendungen, beispielsweise zum Erstellen von Röntgenaufnahmen, für Anwendungen der Fernaufklärung und der Astrophysik sowie für Digitalfotographie.

Die dargestellten Ausführungsbeispiele eignen sich, um Intensitätsmessungen der auftreffenden Strahlung durchzuführen. Bei einer gewünschten Farbmessung können bei einer möglichen Ausführungsform alle Bildaufnahmen für die drei Grundfarben gemacht werden oder es wird auf eine andere Art und Weise eine Farbzerlegung durchgeführt.

Bei einer möglichen Ausführungsform wird für jede Farbe dieselbe Basis-Funktion BF eingesetzt. Bei einer alternativen Ausführungsform kann für jede Farbe auch eine unterschiedliche Basis-Funktion, insbesondere auch eine unterschiedliche Wavelet-Basisfunktion verwendet werden.

**Patentansprüche**

1. Sensorvorrichtung (1) mit
   mehreren übereinander angeordneten Sensorschichten (2), die jeweils aus Sensorelementen (3) bestehen,
   wobei in jeder Sensorschicht (2) durch die Sensorelemente Koeffizienten (c) einer Basis-Funktion (BF) sensorisch erfassbar sind,
   wobei die Sensorelemente (3) der Sensorschichten (2) fest verdrahtet sind um jeweils direkt einen Messwert zu liefern, dessen Größe einem Koeffizienten der Basis-Funktion (BF) entspricht, und
   wobei die Basis-Funktion (BF) eine Wavelet-Basisfunktion ist.

2. Sensorvorrichtung nach Anspruch 1,
   wobei die Sensorvorrichtung (1) eine Bildaufnahme einer auf einer Oberfläche einer obersten Sensorschicht (2-1) auftreffenden Strahlung (S) liefert.

3. Sensorvorrichtung nach Anspruch 2,
   wobei die Sensorvorrichtung (1) eine Bildaufnahme einer elektromagnetischen Strahlung, einer Röntgenstrahlung, einer Gammastrahlung oder einer Teilchenstrahlung liefert.

4. Sensorvorrichtung nach Anspruch 3,
   wobei sich eine Auflösungsfrequenz ($f_A$) einer Sensorschicht (2-i) mit zunehmender Tiefe der Sensorschicht ausgehend von der Oberfläche vermindert und sich die Auflösungswellenlänge ($\lambda_A$) einer Sensorschicht (2-i) mit zunehmender Tiefe der Sensorschicht ausgehend von der Oberfläche erhöht.

5. Sensorvorrichtung nach Anspruch 4,
wobei die Auflösungsfrequenz ($f_A$) einer unterhalb einer Sensorschicht (2-i) liegenden weiteren Sensorschicht (2-i+1) jeweils halb so groß ist wie die Auflösungsfrequenz der darüberliegenden Sensorschicht.

6. Sensorvorrichtung nach einem der Ansprüche 1-5,
wobei die Wavelet-Basisfunktion
eine Haar-Wavelet-Funktion,
eine Coiflet-Wavelet-Funktion,
eine Gabor-Wavelet-Funktion,
eine Daubechies-Wavelet-Funktion,
eine Johnston-Barnard-Wavelet-Funktion oder
eine Bioorthogonal-Spline-Wavelet-Funktion ist.

7. Sensorvorrichtung nach einem der Ansprüche 1-6,
wobei die Sensorelemente (3) CCD- (Charge Couple Device) Sensorelemente und
CMOS- (Complimentary Metal Oxid Semiconductor) Sensorelemente aufweisen.

8. Sensorvorrichtung nach einem der Ansprüche 1-7,
wobei die Sensorschichten (2) aus einem strahlungsdurchlässigen Material bestehen.

9. Sensorvorrichtung nach einem der Ansprüche 1-8,
wobei die Gesamtaufnahmezeit der Sensorvorrichtung (1) der Mindest-Belichtungsdauer der obersten Sensorschicht (2-1) mit der höchsten Auflösungsfrequenz und mit der geringsten Auflösungswellenlänge entspricht.

10. Sensorvorrichtung nach Anspruch 9,
wobei eine Mindest-Belichtungsdauer einer Sensorschicht (2-i) umgekehrt proportional zur Aufnahmefläche eines Sensorelementes (3-i) der jeweiligen Sensorschicht (2-i) ist.

11. Sensorvorrichtung nach Anspruch 10,
wobei die Mindest-Belichtungsdauer einer Sensorschicht (2-i) mit zunehmender Tiefe der Sensorschicht ausgehend von der Oberfläche der Sensorvorrichtung (1) exponentiell abnimmt.

12. Sensorvorrichtung nach Anspruch 11,
wobei die Aufnahmefläche eines Sensorelementes (3) einer Sensorschicht (2) mit zunehmender Tiefe der Sensorschicht
ausgehend von der Oberfläche der Sensorvorrichtung (1) exponentiell zunimmt.

13. Sensorvorrichtung nach einem der Ansprüche 1-12,
wobei die Sensorvorrichtung (1) bei einer Auflösung von $2^N$-Pixeln N übereinander angeordnete Sensorschichten (2) aufweist.

14. Bildaufnahmegerät (5) mit einer Sensorvorrichtung (1) nach einem der Ansprüche 1-13.

15. Bildaufnahmegerät nach Anspruch 14,
wobei das Bildaufnahmegerät (5) ferner eine Signalverarbeitungsvorrichtung (6), insbesondere eine Signalkompressionseinheit, eine Signalfiltereinheit und eine Signalrauschunterdrückungseinheit aufweist.

16. Bildaufnahmegerät nach einem der Ansprüche 14 oder 15, wobei die sensorisch erfassten Koeffizienten (c) der Basis-Funktion (BF) in einem Datenspeicher zwischengespeichert werden.

17. Bildaufnahmegerät nach einem der Ansprüche 14-16,
wobei eine Berechnungseinheit (7) zur Berechnung einer inversen Wavelet-Transformation vorgesehen ist, an die ein Bildschirm (8) angeschlossen ist.

18. Satellit (9) mit einer Sensorvorrichtung nach einem der Ansprüche 1-13, welche die sensorisch erfassten Koeffizienten (c) der Basis-Funktion (BF) über eine Funkschnittstelle an eine Signalverarbeitungsvorrichtung (13) innerhalb einer Bodenstation (12) überträgt.

**19.** Röntgengerät mit einer Sensorvorrichtung (1) nach einem der Ansprüche 1-13.

**20.** Tomograph mit einer Sensorvorrichtung (1) nach einem der Ansprüche 1-13.

**21.** Verfahren zur Aufnahme eines Bildes, bei dem eine Sensorvorrichtung nach einem der Ansprüche 1-13 benutzt wird.

**Claims**

**1.** Sensor device (1) comprising
a plurality of sensor layers (2) arranged vertically one on top of the other, each of which consists of sensor elements (3),
wherein coefficients (c) of a basis function (BF) can be sensorially captured in each sensor layer (2) by means of the sensor elements,
wherein the sensor elements (3) of the sensor layers (2) are permanently wired so that each directly provides a measured value whose size corresponds to a coefficient of the basis function (BF), and
wherein the basis function (BF) is a wavelet basis function.

**2.** Sensor device according to claim 1,
wherein the sensor device (1) provides an image recording of radiation (S) which is incident on a surface of a top sensor layer (2-1).

**3.** Sensor device according to claim 2,
wherein the sensor device (1) provides an image recording of electromagnetic radiation, X-ray radiation, gamma radiation or particle radiation.

**4.** Sensor device according to claim 3,
wherein a resolution frequency ($f_A$) of a sensor layer (2-i) decreases with increasing depth of the sensor layer starting from the surface and the resolution wavelength ($\lambda_A$) of a sensor layer (2-i) increases with increasing depth of the sensor layer starting from the surface.

**5.** Sensor device according to claim 4,
wherein the resolution frequency ($f_A$) of a further sensor layer (2-i+1) lying below a sensor layer (2-i) is in each case half as great as the resolution frequency of the sensor layer lying above it.

**6.** Sensor device according to one of claims 1-5,
wherein the wavelet basis function is
a Haar wavelet function,
a Coiflet wavelet function,
a Gabor wavelet function,
a Daubechies wavelet function,
a Johnston-Barnard wavelet function or
a biorthogonal spline wavelet function.

**7.** Sensor device according to one of claims 1-6,
wherein the sensor elements (3) comprise CCD (Charge Coupled Device) sensor elements and
have CMOS (Complementary Metal Oxide Semiconductor) sensor elements.

**8.** Sensor device according to one of claims 1-7,
wherein the sensor layers (2) consist of a radiation-permeable material.

**9.** Sensor device according to one of claims 1-8,
wherein the total recording time of the sensor device (1) corresponds to the minimum exposure time of the top sensor layer (2-1) at the highest resolution frequency and at the lowest resolution wavelength.

**10.** Sensor device according to claim 9,
wherein a minimum exposure time of a sensor layer (2-i) is inversely proportional to the recording area of a sensor element (3-i) of the respective sensor layer (2-i).

**11.** Sensor device according to claim 10,
wherein the minimum exposure time of a sensor layer (2-i) decreases exponentially with increasing depth of the sensor layer starting from the surface of the sensor device (1).

**12.** Sensor device according to claim 11,
wherein the recording area of a sensor element (3) of a sensor layer (2) increases exponentially with increasing depth of the sensor layer starting from the surface of the sensor device (1).

**13.** Sensor device according to one of claims 1-12,
wherein at a resolution of $2^N$ pixels the sensor device (1) has N sensor layers (2) arranged vertically one on top of the other.

**14.** Image recording apparatus (5) having a sensor device (1) according to one of claims 1-13.

**15.** Image recording apparatus according to claim 14,
wherein the image recording apparatus (5) additionally has a signal processing device (6), in particular a signal compression unit, a signal filtering unit and a signal noise suppression unit.

**16.** Image recording apparatus according to one of claims 14 or 15,
wherein the coefficients (c) of the basis function (BF) captured by sensor are buffered in a data memory.

**17.** Image recording apparatus according to one of claims 14-16,
wherein a calculation unit (7) to which a screen (8) is connected is provided for the purpose of calculating an inverse wavelet transform.

**18.** Satellite (9) having a sensor device according to one of claims 1-13, which sensor device transmits the coefficients (c) of the basis function (BF) captured by sensor via a radio interface to a signal processing device (13) inside a ground station (12).

**19.** X-ray machine having a sensor device (1) according to one of claims 1-13.

**20.** Tomograph having a sensor device (1) according to one of claims 1-13.

**21.** Method for recording an image, wherein a sensor device according to one of claims 1-13 is used.

**Revendications**

**1.** Dispositif de détection (1) avec plusieurs couches de détection (2) superposées qui se composent chacune d'éléments de détection (3), des coefficients (c) d'une fonction de base (BF) pouvant être détectés par capteur dans chaque couche de détection (2) par les éléments de détection (3), les éléments de détection (3) des couches de détection (2) étant câblés pour fournir respectivement directement une valeur de mesure dont la grandeur correspond à un coefficient de la fonction de base (BF) et la fonction de base (BF) étant une fonction de base d'ondelettes.

**2.** Dispositif de détection selon la revendication 1, le dispositif de détection (1) fournissant une prise de vue d'un rayonnement (S) qui frappe une surface d'une couche de détection supérieure (2-1).

**3.** Dispositif de détection selon la revendication 2, le dispositif de détection (1) fournissant une prise de vue d'un rayonnement électromagnétique, d'un rayonnement X, d'un rayonnement gamma ou d'un rayonnement de particules.

**4.** Dispositif de détection selon la revendication 3, une fréquence de résolution ($f_A$) d'une couche de détection (2-i) se réduisant à partir de la surface à mesure que la profondeur de la couche de détection augmente et la longueur d'onde de résolution ($\lambda_A$) d'une couche de détection (2-i) augmentant à partir de la surface à mesure que la profondeur de la couche de détection augmente.

**5.** Dispositif de détection selon la revendication 4, la fréquence de résolution ($f_A$) d'une autre couche de détection (2-i+1) située en dessous d'une couche de détection (2-i) correspondant respectivement à la moitié de la fréquence de résolution de la couche de détection située au-dessus.

6. Dispositif de détection selon l'une des revendications 1 à 5, la fonction de base d'ondelette étant :

   - une fonction d'ondelette de Haar ;
   - une fonction d'ondelette de Coiflet ;
   - une fonction d'ondelette de Gabor ;
   - une fonction d'ondelette de Daubechies ;
   - une fonction d'ondelette de Johnston Barnard ou
   - une fonction d'ondelette biorthogonales splines.

7. Dispositif de détection selon l'une des revendications 1 à 6, les éléments de détection (3) comportant des éléments de détection CCD (Charge Couple Device) et des éléments de détection CMOS (Complementary Metal Oxid Semiconductor).

8. Dispositif de détection selon l'une des revendications 1 à 7, les couches de détection (2) étant composées d'une matière perméable au rayonnement.

9. Dispositif de détection selon l'une des revendications 1 à 8, le temps total de prise de vue du dispositif de détection (1) correspondant à la durée minimale d'exposition de la couche supérieure (2-1) avec la fréquence de résolution maximale et la longueur d'onde de résolution minimale.

10. Dispositif de détection selon la revendication 9, une durée minimale d'exposition d'une couche de détection (2-i) étant inversement proportionnelle à la surface de prise de vue d'un élément de détection (3-i) de la couche de détection respective (2-i).

11. Dispositif de détection selon la revendication 10, une durée minimale d'exposition d'une couche de détection (2-i) décroissant exponentiellement à partir de la surface du dispositif de détection (1) à mesure que la profondeur de la couche de détection augmente.

12. Dispositif de détection selon la revendication 11, la surface de prise de vue d'un élément de détection (3) d'une couche de détection (2) croissant exponentiellement à partir de la surface du dispositif de détection (1) à mesure que la profondeur de la couche de détection augmente.

13. Dispositif de détection selon l'une des revendications 1 à 12, le dispositif de détection (1) comportant, pour une résolution de $2^N$ pixels, N couches de détection superposées (2).

14. Appareil de prise de vue (5) avec un dispositif de détection (1) selon l'une des revendications 1 à 13.

15. Appareil de prise de vue selon la revendication 14, l'appareil de prise de vue (5) comportant en outre un dispositif de traitement de signaux (6), et plus particulièrement une unité de compression de signaux, une unité de filtrage de signaux et une unité de suppression du bruit de signaux.

16. Appareil de prise de vue selon l'une des revendications 14 ou 15, les coefficients (c) détectés par capteur de la fonction de base (BF) étant stockés temporairement dans une mémoire de données.

17. Appareil de prise de vue selon l'une des revendications 14 à 16, pour le calcul d'une transformation inverse par ondelette étant prévue une unité de calcul (7) à laquelle est connecté un écran (8).

18. Satellite (9) avec un dispositif de détection (1) selon l'une des revendications 1 à 13, lequel transmet les coefficients (c) détectés par capteur de la fonction de base (BF) via une interface radio à un dispositif de traitement de signaux (13) à l'intérieur d'une station au sol (12).

19. Appareil à rayons X avec un dispositif de détection (1) selon l'une des revendications 1 à 13.

20. Tomographe avec un dispositif de détection (1) selon l'une des revendications 1 à 13.

21. Procédé de prise de vue dans lequel est utilisé un dispositif de détection selon l'une des revendications 1 à 13.

## FIG 1

FIG 2

S

2-1 → $x_1 = 0, N(x_1)$

2-2 → $x_2, N(x_2)$

2-3 → $x_3, N(x_3)$

2-4 → $x_4, N(x_4)$

3-1 3-1 3-1 3-1 3-1 3-1 3-1 3-1

X

1

3-2 3-3 3-2 3-4 3-2 3-3 3-2

λA

EP 2 274 905 B1

FIG 3A

FIG 3B

3-i

FIG 4

FIG 5

FIG 6

```
        ┌───────────────────────────────────────────────────────┐
        ╎       1                6          7            8        ╎
        ╎    ┌──────┐         ┌──────┐   ┌──────┐     ┌──────┐    ╎
  S     ╎    │      │    c     │      │   │      │     │      │    ╎
 ∿∿∿───▶╎    │      │─────────▶│      │──▶│      │────▶│      │    ╎
        ╎    │      │         │      │   │      │     │      │    ╎
        ╎    └──────┘         └──────┘   └──────┘     └──────┘    ╎
        └───────────────────────────────────────────────────────┘
                                      5
```

FIG 7

```
        ┌─────────────────────┐        ┌──────────────────────────────────────────┐
        ╎   1        10        ╎        ╎   11     13        14          15         ╎
        ╎ ┌──────┐  ┌────┐     ╎        ╎ ┌────┐ ┌──────┐  ┌────┐      ┌────┐       ╎
  S     ╎ │      │c │    │     ╎   c    ╎ │    │ │      │  │    │      │    │       ╎
 ∿∿∿───▶╎ │      │─▶│    │─ ─ ─╎─ ─ ─ ─▶╎ │    │─▶│      │─▶│    │─────▶│    │       ╎
        ╎ │      │  │    │     ╎        ╎ │    │ │      │  │    │      │    │       ╎
        ╎ └──────┘  └────┘     ╎        ╎ └────┘ └──────┘  └────┘      └────┘       ╎
        └─────────────────────┘        └──────────────────────────────────────────┘
                  9                                      12
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7362363 B2